# EUROPÄISCHE PATENTANMELDUNG

(11) **EP 2 308 679 A1**
(43) Veröffentlichungstag der Anmeldung: **13.04.2011**
(21) Anmeldenummer: 09012599.8
(22) Anmeldetag: 06.10.2009
(51) Int. Cl.: B32B 27/36, H01L 31/042

(54) **Solarmodule mit Polycarbonatblend-Folie als Rückseitenfolie**

(71) Anmelder: Bayer MaterialScience AG, 51368 Leverkusen (DE)
(72) Erfinder: Stollwerck, Gunther, Dr., 47802 Krefeld (DE); Reisner, Ernst-Ulrich, 47445 Moers (DE); Petzel-Maryniak, Katrin, 47877 Willich (DE); Seidel, Andreas, Dr., 41542 Dormagen (DE)

(57) **Zusammenfassung**

Die vorliegende Erfindung betrifft Solarmodule enthaltend Polycarbonatblend-Folien als Rückseitenfolien zum Schutz vor Witterung und mechanischer Beschädigung.

## Beschreibung

Die vorliegende Erfindung betrifft Solarmodule enthaltend Polycarbonatblend-Folien als Rückseitenfolien zum Schutz vor Witterung und mechanischer Beschädigung.

Der Aufbau eines Solarmoduls besteht in der Regel aus einer transparenten vorderseitigen Glas-oder Kunststoffplatte oder Kunststoffolie, einer transparenten Schmelzklebeschicht aus Ethylenvinylacetat (EVA) oder thermoplastischem Polyurethan (TPU), in die die Solarzellen eingebettet sind, und einer meist weißen Rückseitenverbundfolie aus Polyvinylfluorid (PVF) und Polyethylenterephthalat (PET). Solche Verbundfolien sind z.B. in WO-A 90/06849 beschrieben. Sie bestehen aus einem PET-Kern, der beidseitig mit einer PVF-Schicht kaschiert wird. Das PET dient als preiswerter aber nicht witterungsstabiler Träger, wohingegen die PVF-Schicht den Witterungsschutz bewirkt. Solche Folien werden heutzutage im großen Stil eingesetzt, haben aber den Nachteil, dass sie aufwendig herzustellen (Extrusion plus Kaschierung) und vergleichsweise teuer sind.

Des Weiteren sind aus der Patentliteratur (JP-A 2006-324556) Rückseitenfolien aus Polycarbonat mit einer anorganischen Oxidschicht als Wasserdampfbarriere bekannt. Nachteilig bei diesen Folien ist jedoch, dass die Oxidschicht meist gleichzeitig als Enthaftungsschicht wirkt, so dass die Rückseitenfolie nach Bewitterung nicht mehr auf der Einbettungsschicht für die Solarzellen haftet.

Aus JP-A 2005-277187 ist ein Solarmodul bekannt, dass vorder- und rückseitig aus gleichartigen Polymerfolien besteht, wobei die rückseitige Folie weiß eingefärbt ist. Das Polymer kann Polycarbonat, Polyethylen oder Polyethylenterephthalat sein. Wenn das Solarmodul keinen starren Träger wie Glas oder dergleichen hat, sind die Solarzellen nicht ausreichend mechanisch gegen Biegung und Zerbrechen geschützt.

Die Aufgabe der vorliegenden Erfindung ist es daher ein Solarmodul bereitzustellen, welches gute Witterungsstabilität (insbesondere Beständigkeit in feucht-warmem Klima) aufweist sowie Schutz gegen mechanische Beschädigung gewährleistet. Vorzugsweise bestand die Aufgabe der vorliegenden Erfindung darin, ein solches Solarmodul bereitzustellen, welches eine Rückseitenfolie enthält, die einfach, d.h. vorzugsweise in einem einzigen Extrusions- oder Coextrusionsschritt, herzustellen ist, und des Weiteren gute Witterungsstabilität (insbesondere Beständigkeit in feucht-warmem Klima) aufweist sowie Schutz gegen mechanische Beschädigung gewährleistet.

Diese Aufgabe wurde erfindungsgemäß dadurch gelöst, dass als Rückseitenfolie für ein Solarmodul eine Folie aus einem Polycarbonatblend eingesetzt wurde, wobei der Polycarbonatblend wenigstens ein aromatisches Polycarbonat und/oder aromatisches Polyestercarbonat, wenigstens ein kautschukhaltiges Pfropfpolymerisat und optional wenigstens ein kautschukfreies Vinylmonomerbasierendes Polymerisat oder Copolymerisat oder alternativ optional wenigstens einen aromatischen Polyester sowie gegebenenfalls ein oder mehrere übliche Polymeradditive enthält.

Gegenstand der vorliegenden Erfindung ist demnach ein Solarmodul enthaltend
- wenigstens eine transparente Glasscheibe, Kunststoffplatte oder Kunststofffolie auf der Vorderseite,
- wenigstens eine ein- oder mehrschichtige Folie auf der Rückseite,
- eine oder mehrere Solarzellen,
- wenigstens eine Schicht aus wenigstens einem transparenten Kunststoff, in die die Solarzellen eingebettet sind, zwischen der transparenten Glasscheibe, Kunststoffplatte oder Kunststoffolie und der ein- oder mehrschichtigen rückseitigen Folie,
**dadurch gekennzeichnet, dass** die ein- oder mehrschichtige Folie auf der Rückseite wenigstens eine Schicht aus einer Zusammensetzung wenigstens enthaltend die folgenden Komponenten aufweist:
A) 30 bis 85 Gew.-Teile, bevorzugt 40 bis 80 Gew.-Teile, besonders bevorzugt 40 bis 70 Gew.-Teile, bezogen auf die Summe der Komponenten A) + B) + C), aromatisches Polycarbonat und/oder aromatisches Polyestercarbonat,
B) 7 bis 70 Gew.-Teile, bevorzugt 13 bis 60 Gew.-Teile, besonders bevorzugt 15 bis 30 Gew.-Teile, bezogen auf die Summe der Komponenten A) + B) + C), mindestens eines kautschukhaltigen Pfropfpolymerisats, in bevorzugter Ausfiihrungsform basierend auf einem Dien-freien Kautschuk als Pfropfgrundlage, in besonders bevorzugter Ausführungsform basierend auf einem Acrylat-Kautschuk,Silikon-Kautschuk oder ganz besonders bevorzugt einem Silikon-Acrylat-Komposit-Kautschuk als Pfropfgrundlage,
C) 0 bis 60 Gew.-Teile, bevorzugt 0 bis 40 Gew.-Teile, besonders bevorzugt 15 bis 30 Gew.-Teile, bezogen auf die Summe der Komponenten A) + B) + C), mindestens eines kautschukfreien Vinylmonomer-basierenden Polymerisats oder Vinylmonomer-basierenden Copolymerisats oder alternativ mindestens eines aromatischen Polyesters,
   wobei die Summe der Komponenten A bis C auf 100 Gew.-Teile normiert ist,
   und gegebenenfalls
D) 0 bis 30 Gew.-Teile, bevorzugt 0,01 bis 20 Gew.-Teile, besonders bevorzugt 0,1 bis 15 Gew.-Teile, bezogen auf die Summe der Komponenten A) + B) + C), wenigstens eines Polymeradditivs.

Bei dem erfindungsgemäßen Solarmodul kann es sich um ein nicht-flexibles oder flexibles Solarmodul handeln. Als Kunststoffplatten oder Kunststofffolien für die Vorderseite kommen bevorzugt solche aus Polycarbonat, Polymethylmethacrylat, Polyethylenterephthalat oder Fluorpolymere in Frage. Geeignete Glasscheiben, Kunststoffplatten oder Kunststofffolien können zudem weitere Beschichtungen, wie z.B. Kratzfestbeschichtungen etc. auf der Vorderseite, d.h. der im Solarmodul nach außen gerichteten Seite aufweisen. Bei der Kunststofffolie kann es sich zudem auch um eine mehrschichtige Verbundfolie handeln. Bevorzugt sind Solarmodule mit einer Glasscheibe auf der Vorderseite.

Die transparente Glasscheibe, Kunststoffplatte oder Kunststofffolie weist bevorzugt eine Dicke von 0.3 mm bis 4 mm auf.

Die Schicht aus wenigstens einem transparenten Kunststoff, in die die Solarzellen eingebettet sind, weist bevorzugt Schmelzklebeeigenschaften auf. Als bevorzugt geeignete Kunststoffe kommen für diese Schicht Ethylenvinylacetat (EVA) , thermoplastische Polyurethan (TPU), Polyvinylbutyral (PVB) oder Silikongummi in Frage.

Als Solarzellen kommen Solarzellen aus mono- oder polykristallinem Silizium oder Dünnschichtsolarzellen in Frage. Bevorzugt enthält das erfindungsgemäße Solarmodul mehrere Solarzellen.

Das erfindungsgemäße Solarmodul kann weiterhin einen Profilrahmen aufweisen. Dieser kann aus Metall, bevorzugt aus Aluminium, oder aus einem bevorzugt witterungsbeständigen Kunststoff bestehen. Er dient beispielsweise dem Schutz der vorderseitigen Glasscheibe, Kunststoffplatte oder Kunststofffolie beim Transport, der Handhabung und Montage sowie für die Befestigung und die Versteifung des Solarmoduls.

Die einzelnen Komponenten der Zusammensetzung für die ein- oder mehrschichtige Folie auf der Rückseite des erfindungsgemäßen Solarmoduls sind im Folgenden im Detail beschrieben.

### Komponente A)

Erfindungsgemäß geeignete aromatische Polycarbonate gemäß Komponente A) sind literaturbekannt oder nach literaturbekannten Verfahren herstellbar (zur Herstellung aromatischer Polycarbonate siehe beispielsweise Schnell, "Chemistry and Physics of Polycarbonates", Interscience Publishers, 1964 sowie die DE-AS 1 495 626, DE-A 2 232 877, DE-A 2 703 376, DE-A 2 714 544, DE-A 3 000 610, DE-A 3 832 396; zur Herstellung aromatischer Polyestercarbonate, z. B. DE-A 3 077 934).

Die Herstellung aromatischer Polycarbonate erfolgt z. B. durch Umsetzung von Diphenolen mit Kohlensäurehalogeniden, vorzugsweise Phosgen und/oder mit aromatischen Dicarbonsäuredihalogeniden, vorzugsweise Benzoldicarbonsäuredihalogeniden, nach dem Phasengrenzflächenverfahren, gegebenenfalls unter Verwendung von Kettenabbrechern, beispielsweise Monophenolen und gegebenenfalls unter Verwendung von trifunktionellen oder mehr als trifunktionellen Verzweigern, beispielsweise Triphenolen oder Tetraphenolen. Ebenso ist eine Herstellung über ein Schmelzepolymerisationsverfahren durch Umsetzung von Diphenolen mit beispielsweise Diphenylcarbonat möglich.

Diphenole zur Herstellung der aromatischen Polycarbonate und/oder aromatischen Polyestercarbonate sind vorzugsweise solche der Formel (I) 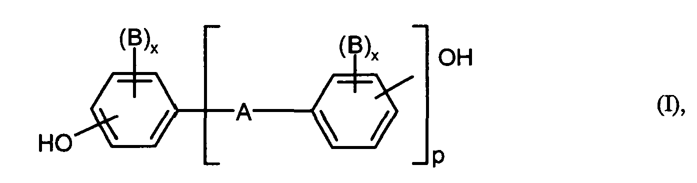 wobei
- A: eine Einfachbindung, C₁ bis C₅-Alkylen, C₂ bis C₅-Alkyliden, C₅ bis C₆-Cycloalkyliden, O-, -SO-, -CO-, -S-, -SO₂-, C₆ bis C₁₂-Arylen, an das weitere aromatische gegebenenfalls Heteroatome enthaltende Ringe kondensiert sein können, oder ein Rest der Formel (II) oder (III) 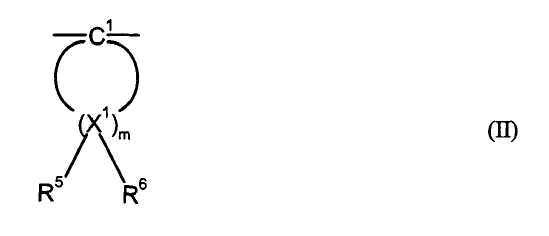 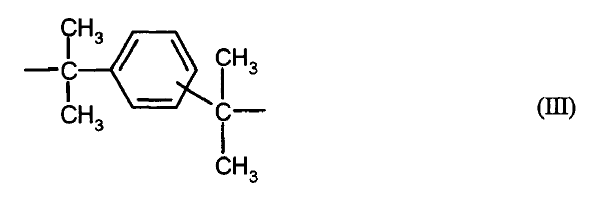 worin
X¹ für Kohlenstoff steht,
R⁵ und R⁶ für jedes X¹ individuell wählbar, unabhängig voneinander für Wasserstoff oder C₁ bis C₆-Alkyl, vorzugsweise Wasserstoff, Methyl oder Ethyl stehen, und
m für eine ganze Zahl von 4 bis 7, bevorzugt 4 oder 5 steht, mit der Maßgabe, dass an mindestens einem Atom X¹, R⁵ und R⁶ gleichzeitig Alkyl sind,
- B: jeweils C₁ bis C₁₂-Alkyl, vorzugsweise Methyl, Halogen, vorzugsweise Chlor und/oder Brom,
- x: jeweils unabhängig voneinander 0, 1 oder 2,
- p: 1 oder 0 sind.

Bevorzugte Diphenole sind Hydrochinon, Resorcin, Dihydroxydiphenole, Bis-(hydroxyphenyl)-C₁-C₅-alkane, Bis-(hydroxyphenyl)-C₅-C₆ -cycloalkane, Bis-(hydroxyphenyl)-ether, Bis-(hydroxyphenyl)-sulfoxide, Bis-(hydroxyphenyl)-ketone, Bis-(hydroxyphenyl)-sulfone und α,α-Bis-(hydroxyphenyl)-diisopropyl-benzole sowie deren kernbromierte und/oder kernchlorierte Derivate.

Besonders bevorzugte Diphenole sind 4,4'-Dihydroxydiphenyl, 2,2-Bis-(4-hydroxyphenyl)-propan (Bisphenol-A), 2,4-Bis(4-hydroxyphenyl)-2-methylbutan, 1,1-Bis-(4-hydroxyphenyl)-cyclohexan, 1,1-Bis-(4-hydroxyphenyl)-3.3.5-trimethylcyclohexan, 4,4'-Dihydroxydiphenylsulfid, 4,4'-Dihydroxydiphenylsulfon sowie deren di- und tetrabromierten oder chlorierten Derivate wie beispielsweise 2,2-Bis(3-Chlor-4-hydroxyphenyl)-propan, 2,2-Bis-(3,5-dichlor-4-hydroxyphenyl)-propan oder 2,2-Bis-(3,5-dibrom-4-hydroxyphenyl)-propan. Insbesondere bevorzugt ist 2,2-Bis-(4-hydroxyphenyl)-propan (Bisphenol-A).

Es können die Diphenole einzeln oder als beliebige Mischungen eingesetzt werden. Die Diphenole sind literaturbekannt oder nach literaturbekannten Verfahren erhältlich.

Für die Herstellung der thermoplastischen, aromatischen Polycarbonate geeignete Kettenabbrecher sind beispielsweise Phenol, p-Chlorphenol, p-tert.-Butylphenol oder 2,4,6-Tribromphenol, aber auch langkettige Alkylphenole, wie 4-[2-(2,4,4-Trimethylpentyl)]-phenol, 4-(1,3-Tetramethylbutyl)-phenol gemäß DE-A 2 842 005 oder Monoalkylphenol oder Dialkylphenole mit insgesamt 8 bis 20 Kohlenstoffatomen in den Alkylsubstituenten, wie 3,5-di-tert.-Butylphenol, p-iso-Octylphenol, p-tert.-Octylphenol, p-Dodecylphenol und 2-(3,5-Dimethylheptyl)-phenol und 4-(3,5-Dimethylheptyl)-phenol. Die Menge an einzusetzenden Kettenabbrechern beträgt im allgemeinen zwischen 0,5 Mol-%, und 10 Mol-%, bezogen auf die Molsumme (Summe der Stoffmengen) der jeweils eingesetzten Diphenole.

Die thermoplastischen, aromatischen Polycarbonate können in bekannter Weise verzweigt sein, und zwar vorzugsweise durch den Einbau von 0,05 bis 2,0 Mol-%, bezogen auf die Summe der Stoffmengen der eingesetzten Diphenole, an dreifunktionellen oder mehr als dreifunktionellen Verbindungen, beispielsweise solchen mit drei und mehr phenolischen Gruppen.

Geeignet sind sowohl Homopolycarbonate als auch Copolycarbonate. Zur Herstellung erfindungsgemäßer Copolycarbonate gemäß Komponente A) können auch 1 bis 25 Gew.-%, vorzugsweise 2,5 bis 25 Gew.-%, bezogen auf die Gesamtmenge an einzusetzenden Diphenolen, Polydiorganosiloxane mit Hydroxyaryloxy-Endgruppen eingesetzt werden. Diese sind bekannt (US 3 419 634) und nach literaturbekannten Verfahren herstellbar. Die Herstellung Polydiorganosiloxanhaltiger Copolycarbonate ist in der DE-A 3 334 782 beschrieben.

Bevorzugte Polycarbonate sind neben den Bisphenol-A-Homopolycarbonaten die Copolycarbonate von Bisphenol-A mit bis zu 15 Mol-%, bezogen auf die Molsummen an Diphenolen, anderen als bevorzugt oder besonders bevorzugt genannten Diphenolen, insbesondere 2,2-Bis(3,5-dibrom-4-hydroxyphenyl)-propan.

Aromatische Dicarbonsäuredihalogenide zur Herstellung von aromatischen Polyestercarbonaten sind vorzugsweise die Disäuredichloride der Isophthalsäure, Terephthalsäure, Diphenylether-4,4'-dicarbonsäure und der Naphthalin-2,6-dicarbonsäure.

Besonders bevorzugt sind Gemische der Disäuredichloride der Isophthalsäure und der Terephthalsäure im Verhältnis zwischen 1:20 und 20:1.

Bei der Herstellung von Polyestercarbonaten wird zusätzlich ein Kohlensäurehalogenid, vorzugsweise Phosgen, als bifunktionelles Säurederivat mit verwendet.

Als Kettenabbrecher für die Herstellung der aromatischen Polyestercarbonate kommen außer den bereits genannten Monophenolen noch deren Chlorkohlensäureester sowie die Säurechloride von aromatischen Monocarbonsäuren, die gegebenenfalls durch C₁ bis C₂₂-Alkylgruppen oder durch Halogenatome substituiert sein können, sowie aliphatische C₂ bis C₂₂-Monocarbonsäurechloride in Betracht.

Die Menge an Kettenabbrechern beträgt jeweils 0,1 bis 10 Mol-%, bezogen im Falle der phenolischen Kettenabbrecher auf die Stoffmenge (Mol) Diphenol und im Falle von Monocarbonsäurechlorid-Kettenabbrecher auf die Stoffmenge (Mol) Dicarbonsäuredichlorid.

Die aromatischen Polyestercarbonate können auch aromatische Hydroxycarbonsäuren eingebaut enthalten.

Die aromatischen Polyestercarbonate können sowohl linear als auch in bekannter Weise verzweigt sein (siehe dazu DE-A 2 940 024 und DE-A 3 007 934).

Als Verzweigungsmittel können beispielsweise drei- oder mehrfunktionelle Carbonsäurechloride, wie Trimesinsäuretrichlorid, Cyanursäuretrichlorid, 3,3'-,4,4'-Benzophenon-tetracarbonsäuretetrachlorid, 1,4,5,8-Napthalintetracarbon-säuretetrachlorid oder Pyromellithsäuretetrachlorid, in Mengen von 0,01 bis 1,0 Mol-% (bezogen auf die Stoffmenge der eingesetzten Dicarbonsäuredichloride) oder drei- oder mehrfunktionelle Phenole, wie Phloroglucin, 4,6-Dimethyl-2,4,6-tri-(4-hydroxyphenyl)-hept-2-en, 4,6-Dimethyl-2,4-6-tri-(4-hydroxyphenyl)-heptan, 1,3,5-Tri-(4-hydroxyphenyl)-benzol, 1,1,1-Tri-(4-hydroxyphenyl)-ethan, Tri-(4-hydroxyphenyl)-phenylmethan, 2,2-Bis[4,4-bis(4-hydroxy-phenyl)-cyclohexyl]-propan, 2,4-Bis(4-hydroxyphenylisopropyl)-phenol, Tetra-(4-hydroxyphenyl)-methan, 2,6-Bis(2-hydroxy-5-methyl-benzyl)-4-methyl-phenol, 2-(4-Hydroxyphenyl)-2-(2,4-dihydroxyphenyl)-propan, Tetra-(4-[4-hydroxyphenyl-isopropyl]-phenoxy)-methan, 1,4-Bis[4,4'-dihydroxytri-phenyl)-methyl]-benzol, in Mengen von 0,01 bis 1,0 Mol-% bezogen auf die Stoffmenge eingesetzte Diphenole verwendet werden. Phenolische Verzweigungsmittel können mit den Diphenolen vorgelegt, Säurechlorid-Verzweigungsmittel können zusammen mit den Säuredichloriden eingetragen werden.

In den thermoplastischen, aromatischen Polyestercarbonaten kann der Anteil an Carbonatstruktureinheiten beliebig variieren. Vorzugsweise beträgt der Anteil an Carbonatgruppen bis zu 100 Mol-%, insbesondere bis zu 80 Mol-%, besonders bevorzugt bis zu 50 Mol-%, bezogen auf die Summe an Estergruppen und Carbonatgruppen. Sowohl der Ester- als auch der Carbonatanteil der aromatischen Polyestercarbonate kann in Form von Blöcken oder statistisch verteilt im Polykondensat vorliegen.

Die relative Lösungsviskosität (ηᵣₑₗ) der aromatischen Polycarbonate und Polyestercarbonate liegt im Bereich 1,20 bis 1,50, bevorzugt von 1,25 bis 1,40, besonders bevorzugt von 1,27 bis 1,35 (gemessen an Lösungen von 0,5 g Polycarbonat oder Polyestercarbonat in 100 ml Methylenchlorid-Lösung bei 25°C).

### Komponente B)

Bei der Komponente B) handelt es sich um ein Pfropfpolymer oder um eine Mischung aus mehreren Pfropfpolymeren. Bevorzugt als Komponente B) zum Einsatz kommende Pfropfpolymere umfassen ein oder mehrere Pfropfpolymerisate von
B.1) 5 bis 95, vorzugsweise 20 bis 90, besonders bevorzugt 25 bis 50 Gew.-%, bezogen auf das Gesamtgewicht der Komponente B), wenigstens eines Vinylmonomeren auf
B.2) 95 bis 5, vorzugsweise 80 bis 10, besonders bevorzugt 75 bis 50 Gew.-%, bezogen auf das Gesamtgewicht der Komponente B), einer oder mehrerer Pfropfgrundlagen mit Glasübergangstemperaturen unterhalb von 10°C, bevorzugt unterhalb von 0°C, besonders bevorzugt unterhalb von -20°C.

Die Glasübergangstemperaturen können mittels dynamischer Differenz-Thermoanalyse (DSC) gemäß einer der Normen DIN EN ISO 11357, DIN 53765 oder DIN EN 61006 bestimmt werden.

Die Pfropfgrundlage B.2) hat im Allgemeinen eine mittlere Teilchengröße (d₅₀-Wert) von 0,05 bis 10 µm, vorzugsweise 0,07 bis 2 µm, besonders bevorzugt 0,1 bis 0,6 µm

Die mittlere Teilchengröße d₅₀ ist der Durchmesser, oberhalb und unterhalb dessen jeweils 50 Gew.-% der Teilchen liegen. Er kann mittels Ultrazentrifugenmessung (W. Scholtan, H. Lange, Kolloid, Z. und Z. Polymere 250 (1972), 782-1796) bestimmt werden.

Monomere B.1) sind vorzugsweise Gemische aus
B.1.1) 50 bis 99, bevorzugt 60 bis 80, besonders bevorzugt 70 bis 80 Gew.-%, bezogen auf das Gesamtgewicht der Komponente B.1), Vinylaromaten und/oder kernsubstituierten Vinylaromaten, wie z.B. Styrol, α-Methylstyrol, p-Methylstyrol, p-Chlorstyrol, und/oder Methacrylsäure-(C₁-C₈)-Alkylestern, wie z.B. Methylmethacrylat, Ethylmethacrylat), und
B.1.2) 1 bis 50, bevorzugt 20 bis 40, besonders bevorzugt 20 bis 30 Gew.-%, bezogen auf B.1), Vinylcyaniden, wie z.B. ungesättigte Nitrile wie Acrylnitril und Methacrylnitril, und/oder (Meth)Acrylsäure-(C₁-C₈)-Alkylestern, wie z.B. Methylmethacrylat, n-Butylacrylat, t-Butylacrylat, und/oder Derivaten (wie Anhydride und Imide) ungesättigter Carbonsäuren, wie z.B. Maleinsäureanhydrid und N-Phenyl-Maleinimid.

Bevorzugte Monomere B.1.1) sind ausgewählt aus mindestens einem der Monomere Styrol, α-Methylstyrol und Methylmethacrylat, bevorzugte Monomere B.1.2) sind ausgewählt aus mindestens einem der Monomere Acrylnitril, Maleinsäureanhydrid und Methylmethacrylat. Besonders bevorzugte Monomerkombinationen sind als B.1.1) Styrol und als B.1.2) Acrylnitril sowie als B.1.1) und als B.1.2) jeweils Methylmethacrylat.

Für die Pfropfpolymerisate B) geeignete Pfropfgrundlagen B.2) sind beispielsweise Dienkautschuke, EP(D)M-Kautschuke, d.h. solche auf Basis Ethylen/Propylen und gegebenenfalls Dien-, Acrylat-, Polyurethan-, Silikon-, Chloropren- und Ethylen/Vinylacetat-Kautschuke sowie Silikon/Acrylat-Kompositkautschuke.

Die Pfropfcopolymerisate B) werden durch radikalische Polymerisation, z.B. durch Emulsions-, Suspensions-, Lösungs- oder Massepolymerisation, vorzugsweise durch Emulsionspolymerisation hergestellt.

Besonders geeignete Pfropfpolymerisate B) besitzten eine Kem-Schale-Struktur.

Der Gelanteil der Pfropfgrundlage B.2) beträgt bei in Emulsionspolymerisation hergestellten Pfropfpolymerisaten mindestens 30 Gew.-%, vorzugsweise mindestens 40 Gew.-% (in Toluol gemessen). Der Gelanteil der Pfropfgrundlage B.2) wird bei 25°C in einem geeigneten Lösungsmittel als in diesen Lösungsmitteln unlöslicher Anteil bestimmt (M. Hoffmann, H. Krömer, R. Kuhn, Polymeranalytik I und II, Georg Thieme-Verlag, Stuttgart 1977).

Da bei der Pfropfreaktion die Pfropfmonomeren bekanntlich nicht unbedingt vollständig auf die Pfropfgrundlage aufgepfropft werden, werden erfindungsgemäß unter Pfropfpolymerisaten B) auch solche Produkte verstanden, die durch (Co)Polymerisation der Pfropfinonomere in Gegenwart der Pfropfgrundlage gewonnen werden und bei der Aufarbeitung mit anfallen. Diese Produkte können demnach auch freies, d.h. nicht chemisch an den Kautschuk gebundenes (Co)Polymerisat der Pfropfmonomere enthalten.

Als Pfropfgrundlage B.2) kommen bei der Herstellung der Pfropfpolymere B) bevorzugt Acrylatkautschuke, Silikonkautschuke oder Silikon/Acrylat-Kompositkautschuke zum Einsatz. Besonders bevorzugt sind Silikon/Acrylat-Kompositkautschuke.

Geeignete Acrylatkautschuke gemäß B.2) sind vorzugsweise Polymerisate aus Acrylsäurealkylestern, gegebenenfalls mit bis zu 40 Gew.-%, bezogen auf B.2), anderen polymerisierbaren, ethylenisch ungesättigten Monomeren. Zu den bevorzugten polymerisierbaren Acrylsäureestern gehören C₁ bis C₈-Alkylester, beispielsweise Methyl-, Ethyl-, Butyl-, n-Octyl-und 2-Ethylhexylester; Halogenalkylester, vorzugsweise Halogen-C₁-C₈-alkylester, wie Chlorethylacrylat, sowie Mischungen dieser Monomeren.

Zur Vernetzung können Monomere mit mehr als einer polymerisierbaren Doppelbindung copolymerisiert werden. Bevorzugte Beispiele für vernetzende Monomere sind Ester ungesättigter Monocarbonsäuren mit 3 bis 8 C-Atomen und ungesättigter einwertiger Alkohole mit 3 bis 12 C-Atomen, oder gesättigter Polyole mit 2 bis 4 OH-Gruppen und 2 bis 20 C-Atomen, wie Ethylenglykoldimethacrylat, Allylmethacrylat; mehrfach ungesättigte heterocyclische Verbindungen, wie Trivinyl- und Triallylcyanurat; polyfunktionelle Vinylverbindungen, wie Di-und Trivinylbenzole; aber auch Triallylphosphat und Diallylphthalat. Bevorzugte vernetzende Monomere sind Allylmethacrylat, Ethylenglykoldimethacrylat, Diallylphthalat und heterocyclische Verbindungen, die mindestens drei ethylenisch ungesättigte Gruppen aufweisen. Besonders bevorzugte vernetzende Monomere sind die cyclischen Monomere Triallylcyanurat, Triallylisocyanurat, Triacryloylhexahydro-s-triazin, Triallylbenzole. Die Menge der vernetzten Monomere beträgt vorzugsweise 0,02 bis 5, insbesondere 0,05 bis 2 Gew.-%, bezogen auf die Pfropfgrundlage B.2). Bei cyclischen vernetzenden Monomeren mit mindestens drei ethylenisch ungesättigten Gruppen ist es vorteilhaft, die Menge auf unter 1 Gew.-% der Pfropfgrundlage B.2) zu beschränken.

Bevorzugte "andere" polymerisierbare, ethylenisch ungesättigte Monomere, die neben den Acrylsäureestern gegebenenfalls zur Herstellung der Pfropfgrundlage B.2 dienen können, sind z.B. Acrylnitril, Styrol, α-Methylstyrol, Acrylamide, Vinyl-C₁-C₆-alkylether, Methylmethacrylat, Butadien. Bevorzugte Acrylatkautschuke als Pfropfgrundlage B.2) sind Emulsionspolymerisate, die einen Gelanteil von mindestens 60 Gew.-% aufweisen.

Die als Pfropfgrundlagen gemäß B.2) bevorzugt zum Einsatz kommenden Silikonkautschuke sind solche mit pfropfaktiven Stellen, wie sie in den DE-OS 3 704 657, DE-OS 3 704 655, DE-OS 3 631 540 und DE-OS 3 631 539 beschrieben werden.

Besonders bevorzugt als Pfropfgrundlagen B.2) sind Kompositkautschuke aus Silikonkautschuk und Acrylatkautschuk, wobei beispielsweise diese beiden Kautschuktypen als physikalisches Gemisch vorliegen oder wobei beispielsweise der Silikonkautschuk und Acrylatkautschuk herstellungsbedingt ein interpenetrierendes Netzwerk ausbilden oder beispielsweise der Silikonkautschuk und Acrylatkautschuk eine Pfropfgrundlage ausbilden, die eine Kem-Schale-Struktur aufweist. Bevorzugte Pfropfgrundlagen B.2) sind Kompositkautschuke von 10 bis 70 Gew.-%, besonders bevorzugt 20 bis 60 Gew.-% Silikonkautschuk und 90 bis 30 Gew.-%, besonders bevorzugt 80 bis 40 Gew.-% Butylacrylatkautschuk (die Angabe der Gew.-% ist hier jeweils bezogen auf das Gesamtgewicht der Pfropfgrundlage B.2)).

Die Silikonacrylat-Kautschuke sind vorzugsweise Komposit-Kautschuke mit pfropfaktiven Stellen, wobei sich der Silikonkautschuk und Acrylatkautschuk im Komposit-Kautschuk gegenseitig durchdringen, so dass sie sich nicht wesentlich voneinander trennen lassen.

Silikonacrylat-Kautschuke sind bekannt und beispielsweise beschrieben in US 5,807,914, EP 430134 und US 4888388.

Bevorzugt werden Silikonkautschuk-Komponenten des Silikonacrylat-Kautschuks gemäß B.2) durch Emulsionspolymerisation hergestellt, bei der der Siloxan-Monomerbausteine, Vemetzungs-oder Verzweigungsmittel und gegebenenfalls Pfropfmittel eingesetzt werden.

Als Siloxan-Monomerbausteine werden beispielsweise und bevorzugt Dimethylsiloxan oder cyclische Organosiloxane mit wenigstens 3 Ringgliedern, vorzugsweise 3 bis 6 Ringgliedern, wie beispielsweise und bevorzugt Hexamethylcyclotrisiloxan, Octamethylcyclotetrasiloxan, Decamethylcyclopentasiloxan, Dodecamethylcyclohexasiloxan, Trimethyl-triphenyl-cyclotrisiloxane, Tetramethyl-tetraphenyl-cyclotetrasiloxane, Octaphenylcyclotetrasiloxan eingesetzt.

Die Organosiloxan-Monomere können allein oder in Form von Mischungen mit 2 oder mehr Monomeren eingesetzt werden. Der Silikonkautschuk enthält vorzugsweise nicht weniger als 50 Gew.-% und besonders bevorzugt nicht weniger als 60 Gew.-% Organosiloxan, bezogen auf das Gesamtgewicht der Silikonkautschuk-Komponente.

Als Vemetzungs- oder Verzweigungsmittel werden vorzugsweise silanbasierende Vernetzungsmittel mit einer Funktionalität von 3 oder 4, besonders bevorzugt 4, verwendet. Beispielhaft und vorzugsweise seien genannt: Trimethoxymethylsilan, Triethoxyphenylsilan, Tetramethoxysilan, Tetraethoxysilan, Tetra-n-propoxysilan und Tetrabutoxysilan. Das Vernetzungsmittel kann allein oder in Mischung von zwei oder mehreren eingesetzt werden. Besonders bevorzugt ist Tetraethoxysilan.

Das Vernetzungsmittel wird in einem Mengenbereich zwischen 0,1 und 40 Gew.%, bezogen auf das Gesamtgewicht der Silikonkautschuk-Komponente, eingesetzt. Die Menge an Vernetzungsmittel wird so gewählt, dass der Quellungsgrad des Silikonkautschuks, gemessen in Toluol, zwischen 3 und 30 liegt, bevorzugt zwischen 3 und 25, und besonders bevorzugt zwischen 3 und 15. Der Quellungsgrad ist definiert als das Gewichtsverhältnis zwischen der Menge Toluol, die durch den Silikonkautschuk absorbiert wird, wenn er mit Toluol bei 25°C gesättigt wird, und der Menge an Silikonkautschuk im getrockneten Zustand. Die Ermittlung des Quellungsgrades ist im Detail in EP 249964 beschrieben.

Tetrafunktionelle Vernetzungsmittel sind bevorzugt gegenüber trifunktionellen, weil dann der Quellungsgrad einfacher kontrollierbarer innerhalb der oben beschriebenen Grenzen ist.

Als Pfropfmittel (IV) geeignet sind Verbindungen, die fähig sind, Strukturen der folgenden Formeln zu bilden:

CH2=C(R⁸)-COO-(CH₂)ₚ-SiR⁷ₙO_{(3-n)/2} (IV-1)

CH₂=CH-SiR⁷ₙO_{(3-n)/2} (IV-2)

oder

HS-(CH₂)ₚ-SiR⁷ₙO_{(3-n)/2} (IV-3),

wobei
- R⁷: für C₁-C₄-Alkyl, vorzugsweise Methyl, Ethyl oder Propyl, oder Phenyl,
- R⁸: für Wasserstoff oder Methyl stehen,
- n: 0, 1 oder 2 und
- p: eine ganze Zahl von 1 bis 6 bedeuten.

Acryloyl- oder Methacryloyloxysilane sind besonders geeignet, die o.g. Struktur (IV-1) zu bilden, und haben eine hohe Pfropfeffizienz. Dadurch wird eine effektive Bildung der Pfropfketten gewährleistet, und somit die Schlagzähigkeit der resultierenden Harzzusammensetzung begünstigt.

Beispielhaft und bevorzugt seien genannt: β-Methacryloyloxy-ethyldimethoxymethyl-silan, γ-Methacryloyloxy-propylmethoxydimethyl-silan, γ-Methacryloyloxy-propyldimethoxymethyl-silan, γ- Methacryloyloxy-propyltrimethoxy-silan, γ-Methacryloyloxy-propylethoxydiethyl-silan, γ-Methacryloyloxy-propyldiethoxymethyl-silan, δ-Methacryloyl-oxy-butyldiethoxymethyl-silane oder Mischungen hieraus.

Bevorzugt werden 0 bis 20 Gew.-% Pfropfmittel bezogen auf das Gesamtgewicht des Silikonkautschuks eingesetzt.

Der Silikonkautschuk kann durch Emulsionspolymerisation hergestellt werden, wie beispielsweise in US 2891920 und US 3294725 beschrieben. Der Silikonkautschuk fällt dabei in Form eines wäßrigen Latex an. Dafür wird ein Gemisch enthaltend Organosiloxan, Vernetzungsmittel und gegebenenfalls Pfropfmittel unter Scherung mit Wasser vermischt, beispielsweise durch einen Homogenisator, in Gegenwart eines Emulgators auf in bevorzugter Ausführungsform Sulfonsäurebasis wie z.B. Alkylbenzolsulfonsäure oder Alkylsulfonsäure, wobei die Mischung zum Silikonkautschuklatex auspolymerisiert. Besonders geeignet ist eine Alkylbenzolsulfonsäure, da sie nicht nur als Emulgator, sondern auch als Polymerisationsinitiator wirkt. In diesem Fall ist eine Kombination der Sulfonsäure mit einem Metallsalz einer Alkylbenzolsulfonsäure oder mit einem Metallsalz einer Alkylsulfonsäure günstig, weil dadurch das Polymer während der späteren Pfropfpolymerisation stabilisiert wird.

Nach der Polymerisation wird die Reaktion beendet, indem die Reaktionsmischung durch Zugabe einer wässrigen alkalischen Lösung neutralisiert wird, z.B. durch Zugabe einer wässrigen Natriumhydroxid, Kaliumhydroxid oder Natriumcarbonat-Lösung.

Geeignete Polyalkyl(meth)acrylatkautschuk-Komponenten der Silikonacrylat-Kautschuke gemäß B.2) können hergestellt werden aus Methacrylsäurealkylestern und/oder Acrylsäurealkylestern, einem Vernetzungsmittel und einem Pfropfmittel. Hierbei sind beispielhafte und bevorzugte Methacrylsäurealkylester und/oder Acrylsäurealkylester die C₁ bis C₈-Alkylester, beispielsweise Methyl-, Ethyl-, n-Butyl-, t-Butyl-, n-Propyl-, n-Hexyl-, n-Octyl-, n-Lauryl- und 2-Ethylhexylester; Halogenalkylester, vorzugsweise Halogen-C₁-C₈-alkylester, wie Chlorethylacrylat sowie Mischungen dieser Monomeren. Besonders bevorzugt ist n-Butylacrylat.

Als Vernetzungsmittel für die Polyalkyl(meth)acrylatkautschuk-Komponente des Silikonacrylat-Kautschuks können Monomere mit mehr als einer polymerisierbaren Doppelbindung eingesetzt werden. Bevorzugte Beispiele für vernetzende Monomere sind Ester ungesättigter Monocarbonsäuren mit 3 bis 8 C-Atomen und ungesättigter einwertiger Alkohole mit 3 bis 12 C-Atomen, oder gesättigter Polyole mit 2 bis 4 OH-Gruppen und 2 bis 20 C-Atomen, wie Ethylenglykoldimethacrylat, Propylenglykoldimethacrylat, 1,3-Butylenglykoldimethacrylat und 1,4-Butylenglykoldimethacrylat. Die Vernetzungsmittel können alleine oder in Gemischen aus mindestsens zwei Vernetzungsmitteln verwendet werden.

Beispielhafte und bevorzugte Pfropfmittel sind Allylmethacrylat, Triallylcyanurat, Triallylisocyanurat oder Mischungen hieraus. Allylmethacrylat kann auch als Vernetzungsmittel eingesetzt werden. Die Pfropfmittel können alleine oder in Gemischen aus mindestens zwei Pfropfmitteln verwendet werden.

Die Menge an Vernetzungsmittel und Pfropfmittel beträgt 0,1 bis 20 Gew.%, bezogen auf das gesamte Gewicht der Polyalkyl(meth)acrylatkautschuk-Komponente des Silikonacrylat-Kautschuks.

Der Silikonacrylat-Kautschuk wird hergestellt, indem zunächst der Silikonkautschuk als wässriger Latex hergestellt wird. Dieser Latex wird anschließend mit den zu verwendenden Methacrylsäurealkylestern und/oder Acrylsäurealkylestern, dem Vernetzungsmittel und dem Pfropfmittel angereichert, und eine Polymerisation wird durchgeführt. Bevorzugt ist eine radikalisch initiierte Emulsionspolymerisation, beispielsweise durch einen Peroxid-, einen Azo-oder Redoxinitiator. Besonders bevorzugt ist die Verwendung eines Redoxinitiatorsystems, speziell eines Sulfoxylat-Initiatorsystems hergestellt durch Kombination von Eisensulfat, Dinatriumethylendiamintetraacetat, Rongalit und Hydroperoxid.

Das Pfropfmittel, das bei der Herstellung des Silikonkautschuks verwendet wird, führt dabei dazu, daß der Polyalkyl(meth)acrylatkautschuk-Anteil kovalent an den Silikonkautschuk-Anteil angebunden wird. Bei der Polymerisation durchdringen sich die beiden Kautschuk-Komponenten gegenseitig und bilden so den Komposit-Kautschuk, der sich nach der Polymerisation nicht mehr in seine Bestandteile aus Silikonkautschuk-Komponente und Polyalkyl(meth)acrylatkautschuk-Komponente trennen lässt.

### Komponente C)

Bei den kautschukfreien Vinyl(Co)Polymerisaten gemäß Komponente C) handelt es sich vorzugsweise um kautschukfreie Homo- und/oder Copolymerisate von mindestens einem Monomeren aus der Gruppe der Vinylaromaten, Vinylcyanide (ungesättigte Nitrile), (Meth)Acrylsäure-(C₁ bis C₈)-Alkylester, ungesättigten Carbonsäuren sowie Derivaten (wie Anhydride und Imide) ungesättigter Carbonsäuren.

Insbesondere geeignet sind (Co)Polymerisate C) aus
C.1) 50 bis 99 Gew.-%, bevorzugt 60 bis 80 Gew.-%, insbesondere 70 bis 80 Gew.-%, jeweils bezogen auf das Gesamtgewicht des (Co)Polymerisats C), mindestens eines Monomeren ausgewählt aus der Gruppe der Vinylaromaten, wie beispielsweise Styrol, α-Methylstyrol, kernsubstituierten Vinylaromaten, wie beispielsweise p-Methylstyrol, p-Chlorstyrol, und (Meth)Acrylsäure-(C₁-C₈)-Alkylester, wie beispielsweise Methylmethacrylat, n-Butylacrylat, tert.-Butylacrylat, und
C.2) 1 bis 50 Gew.-%, bevorzugt 20 bis 40 Gew.-%, insbesondere 20 bis 30 Gew.-%, jeweils bezogen auf das Gesamtgewicht des (Co)Polymerisats C), mindestens eines Monomeren ausgewählt aus der Gruppe der Vinylcyanide, wie beispielsweise ungesättigte Nitrile wie z.B. Acrylnitril und Methacrylnitril, (Meth)Acrylsäure-(C₁-C₈)-Alkylester, wie beispielsweise Methylmethacrylat, n-Butylacrylat, tert.-Butylacrylat, ungesättigte Carbonsäuren und Derivate ungesättigter Carbonsäuren, wie beispielsweise Maleinsäureanhydrid und N-Phenyl-Maleinimid.

Diese (Co)Polymerisate C) sind harzartig, thermoplastisch und kautschukfrei. Besonders bevorzugt ist das Copolymerisat aus C.1) Styrol und C.2) Acrylnitril.

Derartige (Co)Polymerisate C) sind bekannt und lassen sich durch radikalische Polymerisation, insbesondere durch Emulsions-, Suspensions-, Lösungs- oder Massepolymerisation herstellen. Die (Co)Polymerisate besitzen vorzugsweise mittlere Molekulargewichte M_{w} (Gewichtsmittel, ermittelt durch GPC) zwischen 15.000 und 250.000 g/mol, bevorzugt im Bereich 80.000 bis 150.000 g/mol

Als aromatische Polyester kommen bevorzugt Polyalkylenterephthalate in Frage. Polyalkylenterephthalate sind Reaktionsprodukte aus aromatischen Dicarbonsäuren oder ihren reaktionsfähigen Derivaten, wie Dimethylestern oder Anhydriden, und aliphatischen, cycloaliphatischen oder araliphatischen Diolen sowie Mischungen dieser Reaktionsprodukte.

Bevorzugte Polyalkylenterephthalate enthalten mindestens 80 Gew.-%, vorzugsweise mindestens 90 Gew.-%, bezogen auf die Dicarbonsäurekomponente Terephthalsäurereste und mindestens 80 Gew.-%, vorzugsweise mindestens 90 mol-%, bezogen auf die Diolkomponente Ethylenglykol-und/oder Butandiol-1,4-Reste.

Die bevorzugten Polyalkylenterephthalate können neben Terephthalsäureresten bis zu 20 mol-%, vorzugsweise bis zu 10 mol-%, Reste anderer aromatischer oder cycloaliphatischer Dicarbonsäuren mit 8 bis 14 C-Atomen oder aliphatischer Dicarbonsäuren mit 4 bis 12 C-Atomen enthalten, wie z.B. Reste von Phthalsäure, Isophthalsäure, Naphthalin-2,6-dicarbonsäure, 4,4'-Diphenyldicarbonsäure, Bernsteinsäure, Adipinsäure, Sebacinsäure, Azelainsäure, Cyclohexandiessigsäure.

Die bevorzugten Polyalkylenterephthalate können neben Ethylenglykol- bzw. Butandiol-1,4-Resten bis zu 20 mol-%, vorzugsweise bis zu 10 mol-%, andere aliphatische Diole mit 3 bis 12 C-Atomen oder cycloaliphatische Diole mit 6 bis 21 C-Atomen enthalten, z.B. Reste von Propandiol-1,3, 2-Ethylpropandiol-1,3, Neopentylglykol, Pentandiol-1,5, Hexandiol-1,6, Cyclohexan-dimethanol-1,4, 3-Ethylpentandiol-2,4, 2-Methylpentandiol-2,4, 2,2,4-Trimethylpentandiol-1,3, 2-Ethylhexandiol-1,3, 2,2-Diethylpropandiol-1,3, Hexandiol-2,5, 1,4-Di-(β-hydroxyethoxy)-benzol, 2,2-Bis-(4-hydroxycyclohexyl)-propan, 2,4-Dihydroxy-1,1,3,3-tetramethyl-cyclobutan, 2,2-Bis-(4-β-hydroxyethoxy-phenyl)-propan und 2,2-Bis-(4-hydroxypropoxyphenyl)-propan (DE-A 2 407 674, 2 407 776, 2 715 932).

Die Polyalkylenterephthalate können durch Einbau relativ kleiner Mengen 3- oder 4-wertiger Alkohole oder 3- oder 4-basischer Carbonsäuren, z.B. gemäß DE-A 1 900 270 und US-PS 3 692 744, verzweigt werden. Beispiele bevorzugter Verzweigungsmittel sind Trimesinsäure, Trirnellithsäure, Trimethylolethan und -propan und Pentaerythrit.

Besonders bevorzugt sind Polyalkylenterephthalate, die allein aus Terephthalsäure und deren reaktionsfähigen Derivaten (z.B. deren Dialkylestern) und Ethylenglykol und/oder Butandiol-1,4 hergestellt worden sind, und Mischungen dieser Polyalkylenterephthalate.

Mischungen von Polyalkylenterephthalaten enthalten 1 bis 50 Gew.-%, vorzugsweise 1 bis 30 Gew.%, Polyethylenterephthalat und 50 bis 99 Gew.-%, vorzugsweise 70 bis 99 Gew.-%, Polybutylenterephthalat.

Die vorzugsweise verwendeten Polyalkylenterephthalate besitzen im allgemeinen eine Grenzviskosität von 0,4 bis 1,5 dl/g, vorzugsweise 0,5 bis 1,2 dl/g, gemessen in Phenol/o-Dichlorbenzol (1:1 Gewichtsteile) bei 25°C im Ubbelohde-Viskosimeter.

Die Polyalkylenterephthalate lassen sich nach bekannten Methoden herstellen (s. z.B. Kunststoff Handbuch, Band VIII, S. 695 ff., Carl-Hanser-Verlag, München 1973).

### Komponente D)

Die Zusammensetzung kann optional als Komponente D) handelsübliche Polymeradditive enthalten. Als handelsübliche Polymeradditive gemäß Komponente D) kommen Additive wie beispielsweise Flammschutzmittel (beispielsweise Phosphor- oder Halogenverbindungen), Flammschutzsynergisten (beispielsweise nanoskalige Metalloxide), rauchhemmende Additive (beispielsweise Borsäure oder Borate), Antidrippingmittel (beispielsweise Verbindungen der Substanzklassen der fluorierten Polyolefine, der Silikone sowie Aramidfasern), interne und externe Gleit- und Entformungsmittel (beispielsweise Pentaerythrittetrastearat, Montanwachs oder Polyethylenwax), Fließfähigkeitshilfsmittel (beispielsweise niedermolekulare Vinyl(co)polymerisate), Antistatika (beispielsweise Blockcopolymere aus Ethylenoxid und Propylenoxid, andere Polyether oder Polyhydroxyether, Poletheramide, Polyesteramide oder Sulfonsäuresalze), Leitfähigkeitsadditive (beispielsweise Leitruß oder Carbon Nanotubes), Stabilisatoren (beispielsweise UV/Licht-Stabilisatoren, Thermostabilisatoren, Antioxidantien, Umesterungsinhibitoren, Hydrolyseschutzmittel), antibakteriell wirkende Additive (beispielsweise Silber oder Silbersalze), kratzfestigkeitsverbessernde Additive (beispielsweise Silikonöle oder harte Füllstoffe wie Keramik(hohl)kugeln), IR-Absorbentien, optische Aufheller, fluoreszierende Additive, Füll- und Verstärkungsstoffe (beispielsweise Talk, ggf. gemahlene Glas- oder Karbonfasern, Glas- oder Keramik(hohl)kugeln, Glimmer, Kaolin, CaCO₃ und Glasschuppen) sowie Farbstoffe und Pigmente (beispielsweise Ruß, Titandioxid oder Eisenoxid) und Brönstetsaure Verbindungen als Basenfänger, oder aber Mischungen mehrerer der genannten Additive in Frage.

Bevorzugt enthält die Zusammensetzung wenigstens ein Polymeradditiv ausgewählt aus der Gruppe Gleit- und Entformungsmittel, Thermostabilisatoren und Pigmenten.

Als Pigmente kommen bevorzugt Weiß- oder Schwarzpigmente in Frage. In bevorzugten Ausführungsformen enthält die Zusammensetzung wenigstens ein Weißpigment. Geeignete Weißpigmente sind beispielsweise Titandioxid, Zinksulfid, Zirkoniumdioxid oder Bariumsulfat, bevorzugt ist Titandioxid. In bevorzugten Ausführungsformen ist bzw. sind das oder die Pigmente in einer Menge von 0,5 bis 20 Gew.-Teilen, bevorzugt 1 bis 15 Gew.-Teilen, besonders bevorzugt 2 bis 10 Gew.-Teilen, bezogen auf die Summe der Komponenten A) + B) + C), in der Zusammensetzung enthalten.

In weiteren bevorzugten Ausführungsformen der Erfindung enthält die Zusammensetzung kein Pigment. Ausführungsformen ohne Pigmente sind transluzente Folien.

In weiteren bevorzugten Ausführungsformen der Erfindung enthält die Zusammensetzung kein Entformungsmittel.

In weiteren bevorzugten Ausführungsformen der Erfindung enthält die Zusammensetzung als Komponente D) wenigstens eine phosphorhaltige Verbindung als Flammschutzmittel. Diese ist/sind bevorzugt ausgewählt aus den Gruppen der mono- oder oligomeren Phosphor- und Phosphonsäureester, Phosphonatamine und Phosphazene, wobei auch Mischungen von mehreren Komponenten ausgewählt aus einer oder verschiedenen dieser Gruppen als Flammschutzmittel zum Einsatz kommen können. Auch andere hier nicht speziell erwähnte, bevorzugt halogenfreie Phosphorverbindungen können alleine oder in beliebiger Kombination mit anderen, bevorzugt halogenfreien Phosphorverbindungen eingesetzt werden.

Bevorzugte mono- oder oligomere Phosphor- bzw. Phosphonsäureester sind Phosphorverbindungen der allgemeinen Formel (V) 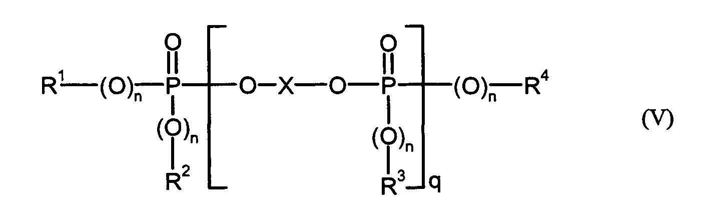 worin
- R¹, R², R³ und R⁴,: unabhängig voneinander jeweils gegebenenfalls halogeniertes C¹ bis C₈-Alkyl, jeweils gegebenenfalls durch Alkyl, vorzugsweise C₁ bis C₄-Alkyl, und/oder Halogen, vorzugsweise Chlor, Brom, substituiertes C₅ bis C₆-Cycloalkyl, C₆ bis C₂₀-Aryl oder C₇ bis C₁₂-Aralkyl,
- n: unabhängig voneinander, 0 oder 1,
- q: 0 bis 30 und
- X: einen ein- oder mehrkernigen aromatischen Rest mit 6 bis 30 C-Atomen, oder einen linearen oder verzweigten aliphatischen Rest mit 2 bis 30 C-Atomen, der OH-substituiert sein und bis zu 8 Etherbindungen enthalten kann, bedeuten.

Bevorzugt stehen R¹, R², R³ und R⁴ unabhängig voneinander für C¹ bis C₄-Alkyl, Phenyl, Naphthyl oder Phenyl-C₁-C₄-alkyl. Die aromatischen Gruppen R¹, R², R³ und R⁴ können ihrerseits mit Halogen- und/oder Alkylgruppen, vorzugsweise Chlor, Brom und/oder C₁ bis C₄-Alkyl substituiert sein. Besonders bevorzugte Aryl-Reste sind Kresyl, Phenyl, Xylenyl, Propylphenyl oder Butylphenyl sowie die entsprechenden bromierten und chlorierten Derivate davon.
- X: in der Formel (V) bedeutet bevorzugt einen ein- oder mehrkernigen aromatischen Rest mit 6 bis 30 C-Atomen. Dieser leitet sich bevorzugt von Diphenolen der Formel (I) ab.
- n: in der Formel (V) kann, unabhängig voneinander, 0 oder 1 sein, vorzugsweise ist n gleich 1.
- q: steht für Werte von 0 bis 30, bevorzugt 0,3 bis 20, besonders bevorzugt 0,5 bis 10, insbesondere 0,5 bis 6, ganz besonders bevorzugt 1,1 bis 1,6.
- X: steht besonders bevorzugt für 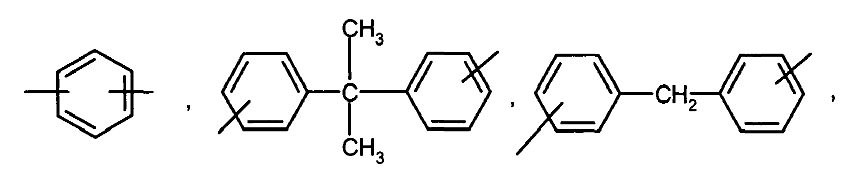 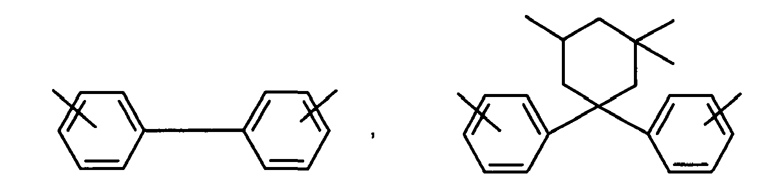
oder deren chlorierte oder bromierte Derivate, insbesondere leitet sich X von Resorcin, Hydrochinon, Bisphenol A oder Diphenylphenol ab. Besonders bevorzugt leitet sich X von Bisphenol A ab.

In bzw. als Komponente D) können auch Mischungen verschiedener Phosphate eingesetzt werden.

Phosphorverbindungen der Formel (V) sind insbesondere Tributylphosphat, Triphenylphosphat, Trikresylphosphat, Diphenylkresylphosphat, Diphenyloctylphosphat, Diphenyl-2-ethylkresylphosphat, Tri-(isopropylphenyl)-phosphat, Resorcin verbrücktes Oligophosphat und Bisphenol A verbrücktes Oligophosphat. Der Einsatz von oligomeren Phosphorsäureestern der Formel (V), die sich vom Bisphenol A ableiten, ist insbesondere bevorzugt.

Eine ganz besonders bevorzugte Phosphorverbindung der Formel (V) ist Bisphenol-A basierendes Oligophosphat gemäß Formel (Va).

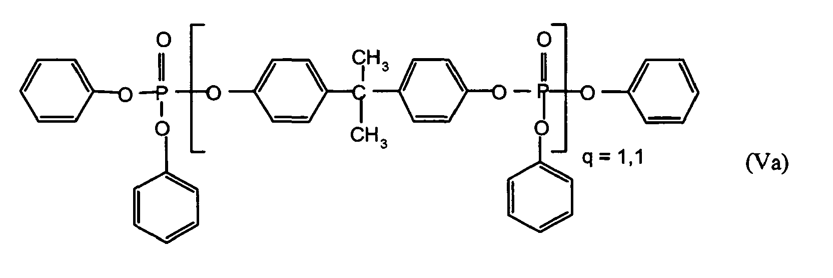

Die vorgenannten Phosphorverbindungen sind bekannt (vgl. z.B. EP-A 0 363 608, EP-A 0 640 655) oder lassen sich nach bekannten Methoden in analoger Weise herstellen (z.B. Ullmanns Enzyklopädie der technischen Chemie, Bd. 18, S. 301 ff. 1979; Houben-Weyl, Methoden der organischen Chemie, Bd. 12/1, S. 43; Beilstein Bd. 6, S. 177).

Wenn Mischungen verschiedener Phosphorverbindungen eingesetzt werden und im Fall von oligomeren Phosphorverbindungen, handelt es sich bei dem angegebenen q-Wert um den mittleren q-Wert. Der mittlere q-Wert kann bestimmt werden, indem mittels geeigneter Methode (Gaschromatographie (GC), High Pressure Liquid Chromatography (HPLC), Gelpermeationschromatographie (GPC)) die Zusammensetzung der Phosphorverbindung (Molekulargewichtsverteilung) bestimmt wird und daraus die Mittelwerte für q berechnet werden.

Weiterhin können Phosphonatamine und Phosphazene, wie sie in WO-A 00/00541 und WO-A 01/18105 beschrieben sind, als Flammschutzmittel eingesetzt werden.

Die Flammschutzmittel können allein oder in beliebiger Mischung untereinander oder in Mischung mit anderen Flammschutzmitteln oder anderen Additiven eingesetzt werden.

Die Flammschutzmittel werden in bevorzugter Ausführungsform in Kombination mit Polytetrafluorethylen (PTFE) als Antidrippingmittel eingesetzt.

Die für die Rückseitenfolie der erfindungsgemäßen Solarmodule geeigneten Zusammensetzungen werden hergestellt, indem man die jeweiligen Bestandteile in bekannter Weise vermischt und bei Temperaturen von 200°C bis 300°C in üblichen Aggregaten wie Innenknetern, Extrudern und Doppelwellenschnecken schmelzcompoundiert und schmelzextrudiert. Die Vermischung der einzelnen Bestandteile kann in bekannter Weise sowohl sukzessive als auch simultan erfolgen, und zwar sowohl bei etwa 20°C (Raumtemperatur) als auch bei höherer Temperatur.

Die ein- oder mehrschichtige Folie auf der Rückseite des erfindungsgemäßen Solarmoduls weist bevorzugt eine Dicke von 100 bis 500 µm, besonders bevorzugt von 200 bis 400 µm auf.

Bei der Folie auf der Rückseite handelt es sich in bevorzugten Ausführungsformen um eine einschichtige Folie.

Bei der Folie auf der Rückseite handelt es sich in weiteren bevorzugten Ausführungsformen um eine mehrschichtige Folie, die wenigstens eine Schicht basierend auf einem thermoplastischen Kunststoff mit einer Wasserdampfdiffusion von weniger als 3 g/m²•d bei 38°C gemessen nach ISO 15106-1 und einer Glasübergangstemperatur von 60 bis 100 °C gemessen mittels dynamischer Differenz-Thermoanalyse (DSC) gemäß einer der Normen DIN EN ISO 11357, DIN 53765 oder DIN EN 61006 aufweist. In besonders bevorzugten Ausfiihrungsformen handelt es sich bei der Folie auf der Rückseite um eine mehrschichtige Folie, die wenigstens eine Schicht basierend auf einem thermoplastischen Kunststoff mit einer Wasserdampfdiffusion von weniger als 3 glm²•d und einer Glasübergangstemperatur von 60 bis 100 °C zwischen wenigstens zwei Schichten aus einer Zusammensetzung enthaltend die Komponenten
A) 30 bis 85 Gew.-Teile, bezogen auf die Summe der Komponenten A) + B) + C), aromatisches Polycarbonat und/oder aromatisches Polyestercarbonat,
B) 7 bis 70 Gew.-Teile, bezogen auf die Summe der Komponenten A) + B) + C), eines kautschukhaltigen Pfropfpolymerisats,
C) 0 bis 60 Gew.-Teile, bezogen auf die Summe der Komponenten A) + B) + C), eines kautschukfreien Vinylmonomer-basierenden Polymerisats oder Vinylmonomer-basierenden Copolymerisats oder alternativ eines aromatischen Polyesters,
   wobei die Summe der Komponenten A bis C auf 100 Gew.-Teile normiert ist,
   und gegebenenfalls
D) 0 bis 30 Gew.-Teile, bezogen auf die Summe der Komponenten A) + B) + C), wenigstens eines handelsüblichen Polymeradditivs,
aufweist.

Die vorangehend genannten Vorzugsbereiche für die einzelnen Komponenten der Zusammensetzung gelten hierfür gleichermaßen.

Bevorzugt weist die Folie auf der Rückseite des Solarmoduls eine Schicht basierend auf einem thermoplastischen Kunststoff mit einer Wasserdampfdiffusion von weniger als 3 g/m²•d und einer Glasübergangstemperatur von 60 bis 100 °C zwischen zwei Schichten aus der vorangehend genannten Zusammensetzung auf.

Als Kunststoffe mit einer Wasserdampfdiffusion von weniger als 3 g/m²•d und einer Glasübergangstemperatur von 60 bis 100 °C kommen beispielsweise solche basierend auf Poly-oder Copolykondensaten der Terephthalsäure, wie beispielhaft Poly- oder Copolyethylenterephthalat (PET oder CoPET), glycol-modifiziertes PET (PETG), glycol-modifiziertes Poly-oder Copolycyclohexandimethylenterephthalat (PCTG) oder Poly- oder Copolybutylenterephthalat (PBT oder CoPBT), in Frage.

Bei der Folie auf der Rückseite des Solarmoduls kann es sich um eine extrudierte oder coextrudierte Folie handeln. Mehrschichtige Folie für die Rückseite des Solarmoduls sind vorzugsweise coextrudierte Folien. Solche Folien sind in nur einem einzigen Extrusionsschritt erhältlich, was beispielsweise zusätzlichen Aufwand für das schrittweise Aufbringen mehrerer Schichten einspart.

Es ist zudem von Vorteil sein, dass die vorangehend beschriebenen Rückseitenfolien eine zusätzliche Haftvermittlerbeschichtung aufweisen, um die Haftung auf dem Einbettungsmaterial für die Solarzelle(n) zu verbessern. Eine derartige Haftvermittlerbeschichtung kann entweder direkt mittels Coextrusion auf der Folie erzeugt werden oder aber nachträglich mittels Extrusionslaminieren oder nasschemischer Verfahren, wie z.B. Rakeln, Sprühen, Gießen, Walzenantrag, Antrag per Extruderdüse etc. aufgebracht werden. Als Haftvermittler eignen sich dabei beispielsweise Polyurethane, beispielsweise eingesetzt als Polyurethandispersionen, Haftvermittler auf Basis von Polymethylmethacrylat (PMMA) oder sonstige Beschichtungen die eine gute Haftung zu den üblichen Einbettungsmaterialien, wie z.B. thermoplastischen Polyurethan oder Ethylenvinylacetat aufweisen.

Die erfindungsgemäß verwendeten Rückseitenfolien bieten für die erfindungsgemäßen Solarmodule einen ausgezeichneten Schutz vor Witterung (insbesondere Beständigkeit in feuchtwarmen Klima) und mechanischer Beschädigung. Die erfindungsgemäßen Solarmodule zeigen entsprechend ausgezeichnete Witterungsbeständigkeit und Hydrolysestabilität bei gutem Schutz vor mechanischer Beschädigung.

Die Verwendung solcher Folien als Rückseitenfolie in Solarmodulen ist bisher nicht bekannt. Daher ist weiterhin Gegenstand der vorliegenden Erfindung eine solche Verwendung einer ein-oder mehrschichtigen Folie enthaltend wenigstens eine Schicht aus einer Zusammensetzung wenigstens enthaltend die folgenden Komponenten
A) 30 bis 85 Gew.-Teile, bezogen auf die Summe der Komponenten A) + B) + C), aromatisches Polycarbonat und/oder aromatisches Polyestercarbonat,
B) 7 bis 70 Gew.-Teile, bezogen auf die Summe der Komponenten A) + B) + C), eines kautschukhaltigen Pfropfpolymerisats,
C) 0 bis 60 Gew.-Teile, bezogen auf die Summe der Komponenten A) + B) + C), eines kautschukfreien Vinylmonomer-basierenden Polymerisats oder Vinylmonomer-basierenden Copolymerisats oder alternativ eines aromatischen Polyesters,
   wobei die Summe der Komponenten A bis C auf 100 Gew.-Teile normiert ist,
   und gegebenenfalls
D) 0 bis 30 Gew.-Teile, bezogen auf die Summe der Komponenten A) + B) + C), wenigstens eines handelsüblichen Polymeradditivs.

Die vorangehend genannten Vorzugsbereiche für die Folie sowie die einzelnen Komponenten der Zusammensetzung gelten hierfür gleichermaßen.

Das erfindungsgemäße Solarmodul kann auf einfache Weise hergestellt werden, indem beispielsweise die einzelnen Schichten zunächst gestapelt und anschließend laminiert werden. Dies kann in einem einzigen Laminierungsschritt oder in mehreren aufeinanderfolgenden Laminierungsschritten erfolgen.

Weiterhin Gegenstand der vorliegenden Erfindung ist daher ein Verfahren zur Herstellung eines erfindungsgemäßen Solarmoduls, **dadurch gekennzeichnet, dass** eine Schichtanordnung aus
a) wenigstens einer transparenten Glasscheibe, Kunststoffplatte oder Kunstofffolie für die Vorderseite
b) wenigstens einer Folie aus einem transparenten Kunststoff
c) Solarzellen
d) wenigstens einer weiteren Folie aus einem transparenten Kunststoff gemäß b)
e) wenigstens einer ein- oder mehrschichtigen Folie für die Rückseite
hergestellt und anschließend laminiert wird.

Dabei bilden die beiden Folien aus einem transparenten Kunststoff gemäß b) und d) durch die Laminierung die Einbettungsschicht(en) für die Solarzelle(n) zwischen der transparenten Glasscheibe, Kunststoffplatte oder Kunststofffolie und der ein oder mehrschichtigen rückseitigen Folie. Bei den Folien gemäß b) und d) handelt es sich daher vorzugsweise um Schmelzklebefolien.

Die folgenden Beispiele dienen der exemplarischen Erläuterung der Erfindung und sind nicht als Beschränkung aufzufassen.

### Beispiele

### Polycarbonat-Zusanunensetzuneen

### Komponente A

Lineares Polycarbonat auf Basis von Bisphenol-A mit einem gewichtsgemittelten Molekulargewicht M_{w} von 32.000 g/mol (bestimmt durch GPC in Methylenchlorid).

### Komponente B

Metablen^{®} SRK200 (Mitsubishi Rayon Co., Ltd., Tokyo, Japan): Pfropfpolymerisat bestehend aus einer Hülle aus Styrol-Acrylnitril-Copolymer auf einem teilchenförmigen Kern aus Silikon-Butylacrylat-Kompositkautschuk, hergestellt in Emulsionspolymerisation.

### Komponente C

Styrol/Acrylnitril-Copolymerisat (SAN) mit einem Styrol-Acrylnitril-Gewichtsverhältnis von 76:24 und einem mittleren Molekulargewicht M_{w} von 100.000 g/mol (bestimmt durch GPC in Dimethylformamid).

### Komponente D

D1: Pentaerythrittetrastearat (PETS) als Gleit-/Enformungsmittel
D2: Irganox^{®} B900 (Ciba Specialty Chemicals, Basel, Schweiz) als Thermostabilisator
D3: Talk als Verstärkungsstoff
D4: Titandioxid als Pigment

**Tab. 1:**

| Für die Herstellung der einzusetzenden Rückseitenfolien verwendete Polycarbonat-Zusammensetzungen (Angaben in Gewichtsteilen) | | | | | | |
|---|---|---|---|---|---|---|
| **Beispiel/Zusammensetzung** | **1** | **2** | **3** | **3a** | **4** | **7** |
| Komponente A (Polycarbonat) | 95 | 90 | 60 | 60 | 80 | 90 |
| Komponente B (Metablen^{®} SRK200) | 5 | 5 | 20 | 20 | 10 | |
| Komponente C (SAN) | - | 5 | 20 | 20 | 10 | |
| Komponente D1 (PETS) | 0,5 | 0,5 | 0,5 | | 0,5 | |
| Komponente D2 (Irganox^{®} B900) | 0,1 | 0,1 | 0,1 | 0,1 | 0,1 | |
| Komponente D3 (Talk) | - | - | - | - | 10 | |
| Komponente D4 (Ti0₂) | 7 | 7 | 7 | 7 | 7 | 10 |

### Herstellung der Rückseitenfolien:

Die einzusetzenden Rückseitenfolien wurden aus Granulat mit den jeweiligen Zusammensetzungen aus der Tab. 1 in einer Dicke von 350 µm extrudiert.

### Beispiel 1 (Vergleichsbeispiel)

Es wurde eine Folie aus Zusammensetzung 1 aus Tab. 1 mittels Extrusion hergestellt.

### Beispiel 2 (Vergleichsbeispiel)

Es wurde eine Folie aus Zusammensetzung 2 aus Tab. 1 mittels Extrusion hergestellt.

### Beispiel 3 (erfindungsgemäß)

Es wurde eine Folie aus Zusammensetzung 3 aus Tab. 1 mittels Extrusion hergestellt.

### Beispiel 3a (erfindungsgemäß)

Es wurde eine Folie aus Zusammensetzung 3a aus Tab. 1 mittels Extrusion hergestellt.

### Beispiel 4 (erfindungsgemäß)

Es wurde eine Folie aus Zusammensetzung 4 aus Tab. 1 mittels Extrusion hergestellt.

### Beispiel 5 (erfindungsgemäß)

Es wurde eine Folie aus Zusammensetzung 3 aus Tab. 1 mittels Extrusion hergestellt und anschließend Haftvermittler (Tedlar^{®} Adhesive 68040 der Firm DuPont) unverdünnt auf die Folie aufgerakelt und bei 120°C getrocknet.

### Beispiel 6 (erfindungsgemäß)

Es wurde eine Mehrschichtfolie mit einer Schicht glycolmodifiziertem Polyethylenterephthalat (PETG) (Easta^{™} DN001 der Firma Eastman) zwischen zwei Schichten aus Zusammensetzung 3 aus Tab. 1 mittels Coextrusion hergestellt, wobei die Dicke der Schichten aus Zusammensetzung 3 jeweils 50 µm und die der PETG-Schicht 250 µm betrug.

### Beispiel 7 (Vergleichsbeispiel)

Es wurde eine Folie aus Zusammensetzung 7 aus Tab. 1 mittels Extrusion hergestellt.

### Beispiel 8 (Vergleichsbeispiel)

Es wurde eine Folie aus Zusammensetzung 7 aus Tab. 1 mittels Extrusion hergestellt und anschließend mit einer 50 nm dicken SiOₓ-Beschichtung beschichtet. Die Beschichtung wurde durch Elektronenstrahlverdampfung von SiO in einer Vakuumkammer mit Sauerstoff-Hintergrunddruck durchgeführt.

### Herstellung und Prüfung der Solarmodule

### Herstellung der Solarmodule

Zur Herstellung der Solarmodule wurde auf eine 4 mm dicke Glasscheibe zuerst eine Ethylenvinylacetat-Folie (EVA-Folie) (Vistasolar^{®} 486.00 der Firma Etimex^{®}, darauf eine kristalline Silizium-Solarzelle, darauf eine weitere EVA-Folie und zuletzt die Rückseitenfolie gemäß einem der Beispiele 1 - 8 gelegt. Dieser Stapel wurde dann in einem Vakuumlaminator LM 50x50 der Firma NPC gelegt. Im Vakuumlaminator wurde das Solarmodul bei 140° innerhalb von 26 Minuten laminiert.

### Prüfung der Solarmodule

Die Solarmodule wurden in Anlehnung an DIN EN 61730-2 einer Bewitterung im Damp Heat Test (Wärme-Feucht-Lagerung für 1000 h bei 85°C und 85% relativer Luftfeuchte) unterzogen. Der Damp Heat Test wurde, um die Langzeiteignung der Folien zu testen, auf 2000 h ausgedehnt. Die Solarmodule wurden nach 500 h, 1000 h und 2000 h aus dem Test genommen und bewertet. Die beiden wichtigsten Kriterien waren: eventuelle Rissbildung in der Rückseitenfolie (aufgrund einer Versprödung der Folie) und Delamination (insbesondere im Randbereich).

**Tab. 2:**

| Verhalten der verschiedenen Solarmodule im Damp Heat Test | | | | | | |
|---|---|---|---|---|---|---|
| | **Bewertung im Damp Heat Test** | | **Bewertung im Damp Heat Test** | | **Bewertung im Damp Heat Test** | |
| | Nach 500 h | | Nach 1000 h | | Nach 2000 h | |
| **Beispiel 1 (V)** | Ra: - | Ri: o | Ra: - | Ri: o | nicht gemessen | |
| **Beispiel 2 (V)** | Ra: - | Ri: o | Ra: - | Ri: o | nicht gemessen | |
| **Beispiel 3 (E)** | Ra: ++ | Ri: ++ | Ra: ++ | Ri: ++ | Ra: ++ | Ri: ++ |
| **Beispiel 3a (E)** | Ra: ++ | Ri: ++ | Ra: ++ | Ri: ++ | Ra: ++ | Ri: ++ |
| **Beispiel 4 (E)** | Ra: + | Ri: + | Ra: o | Ri: o | Ra: o | Ri: o |
| **Beispiel 5 (E)** | Ra: ++ | Ri: ++ | Ra: ++ | Ri: ++ | Ra: ++ | Ri: ++ |
| **Beispiel 6 (E)** | Ra: + | Ri: ++ | Noch im Test | | noch im Test | |
| **Beispiel 7 (V)** | Ra: - | Ri: - | Ra: - | Ri: - | Ra: - | Ri: - |
| **Beispiel 8 (V)** | Ra: - | Ri: - | Ra: - | Ri: - | Ra: - | Ri: - |

| | | | | | | |
|---|---|---|---|---|---|---|
| (V): Vergleichsbeispiel; (E): Erfindungsgemäßes Beispiel; Ra: Randdelamination; Ri: Risse; ++ sehr gut; + gut; o akzeptabel; - schlecht | | | | | | |

Die Daten in Tab. 2 zeigen, dass nur diejenigen Solarmodule auf Basis der erfindungsgemäßen Rückseitenfolien, ein gutes bis sehr gutes Verhalten im Damp Heat Test (Feucht-Warm-Alterungstest) und damit sehr gute Witterungsbeständigkeit aufwiesen. Zudem zeigten die Solarmodule auf Basis der erfindungsgemäßen Rückseitenfolien aufgrund der fehlenden Rissbildung sehr guten Schutz gegen mechanische Beschädigung.

## Patentansprüche

1. Solarmodul enthaltend
- wenigstens eine transparente Glasscheibe, Kunststoffplatte oder Kunststofffolie auf der Vorderseite
- wenigstens eine ein- oder mehrschichtige Folie auf der Rückseite
- eine oder mehrere Solarzellen
- wenigstens eine Schicht aus wenigstens einem transparenten Kunststoff, in die die Solarzellen eingebettet sind, zwischen der transparenten Glasscheibe, Kunststoffplatte oder Kunststoffolie und der ein oder mehrschichtigen rückseitigen Folie,
**dadurch gekennzeichnet, dass** die ein- oder mehrschichtige Folie auf der Rückseite wenigstens eine Schicht aus einer Zusammensetzung wenigstens enthaltend die folgenden Komponenten aufweist:
A) 30 bis 85 Gew.-Teile, bezogen auf die Summe der Komponenten A) + B) + C), aromatisches Polycarbonat und/oder aromatisches Polyestercarbonat,
B) 7 bis 70 Gew.-Teile, bezogen auf die Summe der Komponenten A) + B) + C), eines kautschukhaltigen Pfropfpolymerisats,
C) 0 bis 60 Gew.-Teile, bezogen auf die Summe der Komponenten A) + B) + C), eines kautschukfreien Vinylmonomer-basierenden Polymerisats oder Vinylmonomer-basierenden Copolymerisats oder eines aromatischen Polyesters,
wobei die Summe der Komponenten A bis C auf 100 Gew.-Teile normiert ist,
und gegebenenfalls
D) 0 bis 30 Gew.-Teile, bezogen auf die Summe der Komponenten A) + B) + C), wenigstens eines Polymeradditivs.

2. Solarmodul gemäß Anspruch 1, **dadurch gekennzeichnet, dass** es sich bei der Folie auf der Rückseite um eine ein- oder mehrschichtige Folie mit einer Dicke von 100 bis 500 µm handelt.

3. Solarmodul gemäß Anspruch 1 oder 2, **dadurch gekennzeichnet, dass** es sich bei der Folie auf der Rückseite um eine mehrschichtige Folie handelt, die wenigstens eine Schicht basierend auf einem thermoplastischen Kunststoff mit einer Wasserdampfdiffusion von weniger als 3 g/m²-d und einer Glasübergangstemperatur von 60 bis 100 °C aufweist.

4. Solarmodul gemäß wenigstens einem der Ansprüche 1 bis 3, **dadurch gekennzeichnet, dass** es sich bei der Folie auf der Rückseite um eine mehrschichtige Folie handelt, die wenigstens eine Schicht basierend auf einem thermoplastischen Kunststoff mit einer Wasserdampfdiffusion von weniger als 3 g/m²•d und einer Glasübergangstemperatur von 60 bis 100 °C zwischen wenigstens zwei Schichten aus einer Zusammensetzung enthaltend die Komponenten
A) 30 bis 85 Gew.-Teile, bezogen auf die Summe der Komponenten A) + B) + C), aromatisches Polycarbonat und/oder aromatisches Polyestercarbonat,
B) 7 bis 70 Gew.-Teile, bezogen auf die Summe der Komponenten A) + B) + C), eines kautschukhaltigen Pfropfpolymerisats,
C) 0 bis 60 Gew.-Teile, bezogen auf die Summe der Komponenten A) + B) + C), eines kautschukfreien Vinylmonomer-basierenden Polymerisats oder Copolymerisats oder eines aromatischen Polyesters,
wobei die Summe der Komponenten A bis C auf 100 Gew.-Teile normiert ist,
und gegebenenfalls
D) 0 bis 30 Gew.-Teile, bezogen auf die Summe der Komponenten A) + B) + C), wenigstens eines handelsüblichen Polymeradditivs,
aufweist.

5. Solarmodul gemäß wenigstens einem der Ansprüche 1 bis 4, **dadurch gekennzeichnet, dass** die Zusammensetzung die Komponente C) zu 5 bis 40 Gew.-Teilen, bevorzugt zu 15 bis 25 Gew.-Teilen bezogen auf die Summe der Komponenten A + B + C enthält.

6. Solarmodul gemäß wenigstens einem der Ansprüche 1 bis 5, **dadurch gekennzeichnet, dass** es sich bei der Komponente A) in der Zusammensetzung um ein aromatisches Polycarbonat und/oder aromatisches Polyestercarbonat auf Basis von 2,2-Bis-(4-hydroxyphenyl)-propan (Bisphenol A) handelt.

7. Solarmodul gemäß wenigstens einem der Ansprüche 1 bis 6, **dadurch gekennzeichnet, dass** es sich bei der Komponente B) in der Zusammensetzung um ein Pfropfpolymerisat basierend auf einem Dien-freien Kautschuk, bevorzugt basierend auf einem Acrylatkautschuk und/oder Silikonkautschuk, ganz besonders bevorzugt basierend auf einem Silikon-Acrylat-Komposit-Kautschuk handelt.

8. Solarmodul gemäß wenigstens einem der Ansprüche 1 bis 7, **dadurch gekennzeichnet, dass** die Komponente B) in der Zusammensetzung folgende Komponenten umfasst
B.1) 5 bis 95 Gew.-%, bevorzugt 20 bis 90 Gew.-%, besonders bevorzugt 25 bis 50 Gew.-%, bezogen auf das Gesamtgewicht der Komponente B), wenigstens eines Vinylmonomeren, und
B.2) 95 bis 5 Gew.-%, bevorzugt 80 bis 10 Gew.-%, besonders bevorzugt 75 bis 50 Gew.-%, bezogen auf das Gesamtgewicht der Komponente B), einer oder mehrerer Pfropfgrundlagen mit Glasübergangstemperaturen < 10°C, vorzugsweise < 0°C, besonders bevorzugt < -20°C,
wobei sich die Gewichtsteile der Komponenten B.1) und B.2) zu 100 Gew.-% addieren.

9. Solarmodul gemäß Anspruch 8, **dadurch gekennzeichnet, dass** die Komponente B.1) in der Zusammensetzung ein Gemisch aus folgenden Monomeren ist
B.1.1) 50 bis 99 Gew.-%, bevorzugt 60 bis 80 Gew.-%, besonders bevorzugt 70 bis 80 Gew.-%, bezogen auf das Gesamtgewicht der Komponente B.1), Vinylaromaten und/oder kernsubstituierten Vinylaromaten und/oder Methacrylsäure-(C₁-C₈)-Alkylester und
B.1.2) 1 bis 50 Gew.-%, bevorzugt 20 bis 40 Gew.-%, insbesondere 20 bis 30 Gew.-%, bezogen auf das Gesamtgewicht der Komponente B.1), Vinylcyanide und/oder (Meth)Acrylsäure-(C₁-C₈)-Alkylester und/oder Derivate ungesättigter Carbonsäuren,,
wobei sich die Gewichtsteile der Komponenten B.1.1) und B.1.2) zu 100 Gew.-% addieren.

10. Solarmodul gemäß wenigstens einem der Ansprüche 1 bis 9, **dadurch gekennzeichnet, dass** es sich bei Komponente C) in der Zusammensetzung um ein Polymerisat oder Copolymerisat aus einem oder mehreren Monomer(en) ausgewählt aus der Gruppe der Vinylaromaten, kernsubstituierten Vinylaromaten, Vinylcyaniden, (Meth)Acrylsäure-(C₁-C₈)-Alkylester, ungesättigter Carbonsäuren und Derivaten ungesättigter Carbonsäuren handelt.

11. Solarmodul gemäß wenigstens einem der Ansprüche 1 bis 10, **dadurch gekennzeichnet, dass** die Komponente D) in der Zusammensetzung zu 0,01 bis 20 Gew.-Teile, bezogen auf die Summe der Komponenten A) + B) + C), enthalten ist.

12. Solarmodul gemäß wenigstens einem der Ansprüche 1 bis 11, **dadurch gekennzeichnet, dass** es sich bei der Komponente D) in der Zusammensetzung wenigstens um ein Polymeradditiv ausgewählt aus der Gruppe Gleit- und Entformungsmittel, Thermostabilisatoren und Pigmenten handelt.

13. Solarmodul gemäß wenigstens einem der Ansprüche 1 bis 12, **dadurch gekennzeichnet, dass** die Komponente D) in der Zusammensetzung wenigstens ein Weißpigment, bevorzugt Titandioxid, umfasst, welches in einer Menge von 0,5 bis 20 Gew.-Teilen, bevorzugt 1 bis 15 Gew.-Teilen, besonders bevorzugt 2 bis 10 Gew.-Teilen, bezogen auf die Summe der Komponenten A) + B) + C), in der Zusammensetzung enthalten ist.

14. Verfahren zur Herstellung eines Solarmoduls gemäß wenigstens einem der Ansprüche 1 bis 13, **dadurch gekennzeichnet, dass** eine Schichtanordnung aus
a) wenigstens einer transparenten Glasscheibe, Kunststoffplatte oder Kunstofffolie für die Vorderseite
b) wenigstens einer Folie aus einem transparenten Kunststoff
c) Solarzellen
d) wenigstens einer weiteren Folie aus einem transparenten Kunststoff gemäß b)
e) wenigstens einer ein- oder mehrschichtigen Folie für die Rückseite
hergestellt und anschließend laminiert wird.

15. Verwendung einer ein- oder mehrschichtigen Folie enthaltend wenigstens eine Schicht aus einer Zusammensetzung wenigstens enthaltend die folgenden Komponenten:
A) 30 bis 85 Gew.-Teile, bezogen auf die Summe der Komponenten A) + B) + C), aromatisches Polycarbonat und/oder aromatisches Polyestercarbonat,
B) 7 bis 70 Gew.-Teile, bezogen auf die Summe der Komponenten A) + B) + C), eines kautschukhaltigen Pfropfpolymerisats,
C) 0 bis 60 Gew.-Teile, bezogen auf die Summe der Komponenten A) + B) + C), eines kautschukfreien Vinylmonomer-basierenden Polymerisats oder Vinylmonomer-basierenden Copolymerisats oder eines aromatischen Polyesters,
wobei die Summe der Komponenten A bis C auf 100 Gew.-Teile normiert ist,
und gegebenenfalls
D) 0 bis 30 Gew.-Teile, bezogen auf die Summe der Komponenten A) + B) + C), wenigstens eines handelsüblichen Polymeradditivs.
als Rückseitenfolie in Solarmodulen.
